# EUROPEAN PATENT APPLICATION

(11) **EP 4 047 378 A1**
(43) Date of publication of application: **24.08.2022**
(21) Application number: 21382135.8
(22) Date of filing: 19.02.2021
(51) Int. Cl.: G01R 19/32

(54) **METHOD FOR CHARACTERIZING A CURRENT SENSOR AND CURRENT SENSOR**

(71) Applicant: Fico Triad, S.A., 08028 Barcelona (ES)
(72) Inventor: ABOMAILEK RUBIO, Carlos, 08232 Viladecavalls (ES); DURÁN RIVAS, Raúl, 08232 Viladecavalls (ES)
(74) Representative: Elzaburu S.L.P.

(57) **Abstract**

Method for characterizing a current sensor to calculate a thermal compensation of a sensed current. The current sensor comprising an electronic control unit (ECU) and a shunt resistor. The shunt resistor manufactured from a portion of a batch of an alloy material. The method comprising the steps of:
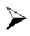 providing a shunt resistor and a batch characterization data of resistivity or resistance versus temperature R_{batch}(T) linked to the shunt resistor,
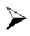 mounting the shunt resistor to the current sensor,
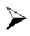 measuring a reference temperature (T) at the current sensor,
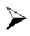 obtaining a measured resistance (R_{T}) of the current sensor at the reference temperature (T); and
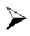 storing in the electronic control unit (ECU):
- the batch characterisation data R_{batch}(T) linked to the shunt resistor;
- the reference temperature (T) at the current sensor; and
- the measured resistance (R_{T}) of the current sensor at the reference temperature (T).

## Description

### Field of the invention

The present invention refers to a method for characterizing a current sensor configured to calculate a thermal compensation of a sensed current and to the current sensor. In particular, it refers to a current sensor that, in turn, comprises a shunt resistor.

### Background of the invention

Current sensors are designed to determine the value of circulating current throughout an electric circuit. For example, from a vehicle's electric charger to the vehicle's own battery, or alternatively, from the battery to the inverter which, in turn, will go to the electric motor.

Current sensors usually, but not exclusively, include at least one shunt resistor. Current sensors based in shunt resistors are already well-known. Shunt resistors are a low-resistance resistor usually made of a Copper-Manganin Cu-Mn alloy and with highly conductive bus-bars. They are used to measure currents within electric circuits.

Current sensors comprise at least a circuit board, an electronic control unit (ECU) mounted on the circuit board and a shunt resistor mounted onto the circuit board. The shunt resistor comprises a first and a second end. Current sensors may comprise other elements like a temperature sensor or a voltmeter comprising two terminals connected to the ends of the shunt resistor and configured to measure the voltage drop at the shunt resistor.

Current sensors are able to determine the intensity (I) that circulates through the shunt resistor during, for instance, the life of a vehicle. The electronic control unit (ECU) of the current sensor is able to determine the intensity, current, by Ohm's Law: I = V / R. The voltage V is the voltage drop between the terminals of the shunt resistor.

The two parameters that influence current sensing are:
- temperature, i.e., the ambient temperature where the current sensor is located, and
- composition of the shunt material, i.e., the exact percentages of the manganin alloy the shunt resistor is made of.

Therefore conductivity, which is the inverse of resistivity of the shunt resistor, is fundamentally dependent on the two mentioned parameters: the material the shunt resistor is made of, for instance the percentage of manganin alloy, and the ambient temperature of the current sensor.

In order to overcome the problems associated with the temperature drift, the electronic control unit can be used for thermal drift compensation and calibration of the shunt resistor.

According to the above, the resistance R of the current sensor is the resistance re-calculated by the electronic control unit as a function of the temperature at a precise moment.

The thermal drift compensation of the current sensor is therefore made to correct the more than possible deviations of the sensing due to temperature of the current sensor and composition of the shunt resistor material.

A known method for calculation the thermal compensation of a current sensor consists of introducing the shunt resistors into a temperature-varying chamber, or what is the same, a temperature-controlled oven, and measuring the variation of the resistance of the shunt resistor with the temperature and obtain what is called the characterization data of the shunt resistor. Afterwards, the shunt resistor is mounted to the circuit board of the current sensor and an end-of-line test is performed to each current sensor that is introduced into the temperature-varying chamber to calculate the thermal compensation of the current sensor.

These two steps are usually performed in two separated sites, as the manufacturer of the shunt resistors obtain the characterization data of the shunt resistor and afterwards provide them to the manufacturer of the current sensor.

Therefore, the first step consists of the characterization of the electrical resistance of the shunt resistors. The characterization, which is nothing more than finding the characterization curve of the shunt resistance at different temperatures. That is, how the resistance changes as a function of temperature.

Nowadays, end-of-line-testing (EOLT) of current sensors base its working principle in measuring the voltage drop caused by the circulation of a current through a shunt resistor of a current sensor and are performed as follows.

First of all, the current sensor is assembled according to the specific assembly method of the device. Following, a test of sensitivity of the measure against the variation on temperature is carried out to calculate the thermal compensation of the current sensor.

The test consists in introducing a group of current sensors interconnected in series in a temperature-varying chamber by means of a conductor that connects each of the terminals of the current sensor with the following. Afterwards, a controlled current is input through the group of current sensors. This procedure is repeated at different temperatures in order to calculate the thermal compensation of each sensor, i.e., the resistance versus temperature variations.

The aforementioned method, although technically valid, is time-consuming and not feasible in a continuous mass-production line, as temperature-varying chambers require time to reach steady-state temperatures and are limited in size.

Specifically, in the field of electric battery projects in the electric vehicle industry, the production volume and number of units of current sensors is increasing considerably. It is not possible on an automotive scale, mass production, to introduce each of the current sensors into a temperature-varying chamber for calibration.

### Summary of the invention

One of the objectives of the present invention is to provide a method for calculating the thermal compensation of a current sensor for reducing the testing time of a current sensor, in particular, to avoid the introduction of each current sensor into a temperature-varying chamber for performing said calculation of the thermal compensation.

For the method object of the invention, it is considered that the shunt resistor is manufactured from a portion of a batch of an alloy material. Batch is understood for this invention as the partial quantity of a material alloy with homogeneous characteristics.

The claimed method makes use of the fact that most of the temperature variation of the current sensor is due to the change of properties of the shunt resistor due to temperature variations. Thus, the resistance will have a similar behavior for the shunt resistors made of the same batch of alloy material.

The current sensor object of the invention comprises an electronic control unit (ECU) and a shunt resistor connected to the electronic control unit (ECU). The shunt resistor is manufactured from a portion of a batch of an alloy material.

The method for characterizing a current sensor configured to calculate a thermal compensation of a sensed current object of the invention comprises the steps of:
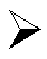 Providing a shunt resistor and a batch characterization data of resistivity or resistance versus temperature R_{batch}(T) linked to the shunt resistor. Thus, to make available or supply a shunt resistor and the characterization data linked to said shunt resistor which is made from a batch of an alloy material. This is the first step of the method, the shunt resistor is of the kind that has been previously characterized to obtained resistivity or resistance versus temperature R_{batch}(T), for instance, in a temperature-varying chamber.
   In an embodiment, the batch characterization data R_{batch}(T) of the shunt resistor comprise:
   - two or more resistivity values measured at two temperatures of the batch of alloy material of the current sensor shunt resistor, or
   - two or more resistance values measured at two temperatures of one of the shunt resistors made from the same batch of alloy material than the current sensor shunt resistor.
   Thus, the batch characterization data R_{batch}(T) may come from the characterization of the alloy material used to manufacture the shunt resistor's batch or from the characterization of the particular shunt resistor installed in the current sensor or from the characterization of another different shunt resistor of the same batch material.
   In an embodiment, the batch characterization data R_{batch}(T) of the shunt resistor comprises a look-up table of resistivity or resistance versus temperature or a functional dependence giving the resistivity or resistance as a function of the temperature.
   Electrical resistivity is a property of a material that quantifies how strongly it resists or conducts electric current. The SI unit of electrical resistivity is the ohm-meter (Ω·m). In that case, the characterization data R_{batch}(T) of the batch of alloy material provides resistivity versus temperature.
   Resistance is a measure of the opposition to current flow in an electrical circuit. Resistance is measured in ohms (Ω). Alternatively, the batch characterization data R_{batch}(T) of a shunt resistor provides resistance versus temperature.
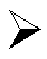 Mounting the shunt resistor linked to the batch characterization data of resistivity or resistance versus temperature R_{batch}(T) to the current sensor. In an embodiment, the shunt resistor is mounted to the current sensor by connecting the shunt resistor to the electronic control unit (ECU). It can be made, for instance, by welding.
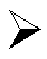 Measuring by a temperature sensor a reference temperature (T) at the current sensor.
   The temperature may be the ambient temperature in which the current sensor is located. It can be measured by a temperature sensor, for instance, a thermometer located in the room in which the characterization of the current sensor is carried out or by a temperature sensor located in the current sensor or by any thermometer placed at any location as near as possible of the shunt resistor.
   Only one reference temperature (T) is measured, and this step is performed after the shunt resistor is mounted in the current sensor and thus after the characterization data of the shunt resistor are obtained. One of the advantages of the present method is that a reference temperature (T) is measured which is a temperature that can be obtained without the need of a temperature-varying chamber as it can be, for instance, the ambient temperature.
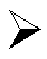 Obtaining a measured resistance (R) of the current sensor at the reference temperature (T);
   In an embodiment it is carried out by Ohms Law R_{T}=V/I, by providing to the current sensor a set current or a set voltage drop and measuring the voltage drop or the current, accordingly.
   More particularly in an embodiment, the measured resistance (R_{T}) of the current sensor is obtained at, for instance, the ambient temperature by dividing the measured voltage drop by the provided Current, R_{T}=V_{measured}/I_{provided}
   In this particular embodiment, the following steps could be performed:
   ∘ Connecting a first terminal and a second terminal of the current sensor to outputs of a current supply. The current supply is adapted to provide the current sensor with a current (I_{provided}).
   ∘ Connecting the first and the second end of the shunt resistor to inputs of a voltmeter. The voltmeter is adapted to measure the voltage drop (V_{measured}) at the shunt resistor caused by the provided current (I_{provided}).
   ∘ Providing the current sensor with a current (I_{provided}) from the current supply.
   ∘ Measuring the voltage drop (V_{measured}) at the shunt resistor with the voltmeter at the reference temperature (T), for instance, the ambient temperature.
   ∘ Obtaining the measured resistance (R_{T}) of the current sensor at the reference temperature (T) by dividing the measured voltage drop (V_{measured}) by the provided current (I_{provided}), R_{T}=V_{measured/}I_{provided} .
   Other methods for obtaining a measured resistance (R_{T}) of the current sensor at the reference temperature (T) would be possible, such as mass spectrometry.
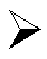 Storing in the electronic control unit (ECU) of the current sensor the following data:
   - the batch characterisation data R_{batch}(T) linked to the shunt resistor;
   - the reference temperature (T) at the current sensor; and
   - the measured resistance (R_{T}) of the current sensor at the reference temperature (T).
   In an embodiment, the electronic control unit (ECU) is configured to calculate, with the above stored data, a current (I₁) circulating through the current sensor by multiplying a measured voltage drop (V₁) at the ends of the shunt resistor by the resistance (R_{batch}(T₁)) at a reference temperature (T₁), i.e., the resistance of the current sensor considering the thermal compensation.
   Said resistance (R_{batch}(T₁)), i.e. the resistance of the current sensor considering the thermal compensation, is obtained from the measured resistance (R_{T}) of the current sensor at the reference temperature (T) and the batch characterization data R_{batch}(T) linked to the shunt resistor, R_{batch}(T₁)=R_{T}+R_{batch}(T).

Thus, for providing the characterization of the current sensor and calculating the thermal compensation, a characterization of the variation of the resistance or the resistivity with the temperature of the material or the shunt resistors manufactured from the same batch of material is provided. The purity and composition of manganin in the alloy will always be significantly different for each batch, so it is advantageous to characterize each of the different batches.

In an embodiment, the step of storing in the electronic control unit (ECU) of the current sensor the batch characterisation data R_{batch}(T) linked to the shunt resistor comprises the step of reading by a reading machine an identification code marked on the shunt resistor and linked to the batch characterisation data R_{batch}(T) of the shunt resistor.

In an embodiment, a previous step of obtaining the characterization data of the shunt resistor is performed, variation of resistivity vs. temperature or resistance vs. temperature, of each of the batches of the alloy material.

After the aforementioned batch characterization R_{batch}(T) of the shunt resistor, in an embodiment, every shunt resistor is marked with the alloy resistance variation with temperature, which may be common for the group of shunt resistors manufactured from the same batch of material. The shunt resistor may be marked with a QR code made by laser on the surface of the shunt resistor.

The resistance of the current sensor is then obtained at, for instance, ambient temperature and the variation of resistance versus temperature of the shunt resistor is added to the electronics of the current sensor.

The above method avoids a long-lasting characterization of the full electronics at different temperatures, as the main source of measure variation with respect to temperature is caused by the resistance drift at the shunt resistor. Thus, the invention avoids the need to introduce every one of the current sensors into a temperature-varying chamber.

It is also an object of the invention a method of current measurement for a motor vehicle comprising the steps of:
- characterizing a current sensor according to the above method for characterizing a current sensor;
- obtaining an operating temperature (T₁), for instance, the temperature of the vehicle's surroundings;
- providing the electronic control unit (ECU) of the current sensor with the operating temperature (T₁);
- calculating the thermal compensation of the resistance value
   (R_{batch}(T₁)) at the operating temperature (T₁) based on:
   - the batch characterisation data R_{batch}(T) of the shunt resistor;
   - the reference temperature (T) of the current sensor in the characterizing steps; and
   - the measured resistance (R_{T}) of the current sensor at the reference temperature (T),
- determining, by the electronic control unit (ECU), a current (I₁) circulating through the current sensor from the thermally compensated resistance value.

As previously stated in an embodiment, the current (I₁) is determined by Ohm's Law: I = V / R, being the resistance R, the resistance (R_{batch}(T₁)) at a reference temperature (T₁). (R_{batch}(T₁)) is obtained from the measured resistance (R_{T}) of the current sensor at the reference temperature (T) and the batch characterization data R_{batch}(T) linked to the shunt resistor, R_{batch}(T₁) = R_{T}+R_{batch}(T).

It is also an object of the invention a current sensor in which the shunt resistor is manufactured from a portion of a batch of an alloy material.

The current sensor is configured to calculate a thermal compensation of a sensed current. The current sensor comprises an electronic control unit (ECU), a shunt resistor connected to the electronic control unit (ECU). The electronic control unit (ECU) of the current sensor comprising the following data:
- batch characterisation data R_{batch}(T) of the shunt resistor;
- a characterization reference temperature (T) at the current sensor; and
- a characterization measured resistance (R_{T}) of the current sensor at the reference temperature (T),
the electronic control unit (ECU) being configured to:
- be provided with an operating temperature (T₁);
- calculate the thermal compensation of the resistance value (R_{batch}(T₁)) at the operating temperature (T₁) based on:
   - the batch characterisation data R_{batch}(T) of the shunt resistor;
   - the reference temperature (T) at the current sensor of the characterizing steps; and
   - the measured resistance (R_{T}) of the current sensor at the reference temperature (T),
- determine, by the electronic control unit (ECU), a current (I₁) circulating through the current sensor from the thermally compensated resistance value.

In an embodiment, the current sensor further comprises a voltmeter connected to the electronic control unit (ECU) and comprising two terminals connected to the ends of the shunt resistor. The electronic control unit (ECU) of the current sensor comprises batch characterization data R_{batch}(T) of the shunt resistor, the characterization data comprising:
- two or more resistivities measured at two temperatures of the batch of alloy material of the current sensor shunt resistor, or
- two or more resistances measured at two temperatures of one of the shunt resistors made from the same batch of alloy material than the current sensor shunt resistor.

The electronic control unit (ECU) of the current sensor is configured to calculate:
- a current (I₁) circulating through the current sensor by multiplying a voltage drop (V₁) measured the voltmeter at the ends of the shunt resistor by the resistance (R_{batch}(T₁)) at a reference temperature (T₁), and
- the resistance (R_{batch}(T₁)) from a characterization of a measured resistance (R_{T}) at a reference temperature and the batch characterization data R_{batch}(T) of the shunt resistor, R_{batch}(T₁) = R_{T}+R_{batch}(T).

Once the current sensor is characterized, the current sensor is configured to recalculate the shunt resistor resistance when the shunt resistor is not at the reference temperature. The electronic control unit (ECU) of the current sensor will be able to determine with exactitude, which resistance (R_{batch}(T₁)) presents the shunt resistor to the temperature T₁ that reads, for instance, a temperature sensor located in the current sensor.

Mathematically, the current sensor re-calculates the shunt resistor resistance according to the temperature obtained at every moment during the vehicle's life. For instance, when the temperature drops to 5°C, the electronic control unit (ECU) of the current sensor will recalculate the resistance of the shunt resistor at 5°C.

In the electric vehicle industry, one of the objectives is to determine the kilometers of autonomy left in the car battery. The current sensor will calculate the current (I) by dividing the voltage drop (V) in the shunt resistor, by the resistance (R) of the shunt resistor itself. But as the resistance, as commented, varies depending on the temperature, the current sensor will re-calculate the resistance from the temperature at that precise moment.

### Description of the figures

To complete the description and to provide for a better understanding of the invention, a set of drawings is provided. Said drawings form an integral part of the description and illustrate preferred embodiments of the invention. The drawings comprise the following figures.
Figure 1 shows a block diagram of an embodiment of the steps of a method for characterizing a current sensor.
Figure 2 shows a flowchart of an embodiment of the steps of the batch characterization of the shunt resistor.
Figure 3 shows an embodiment of a shunt resistor marked with an identification code linked to the characterisation data R_{batch}(T) of the shunt resistor.
Figure 4 shows an embodiment of the curve of variation of resistance with temperature in a shunt resistor.
Figure 5 shows a block diagram of an embodiment of the steps of a method for characterizing a shunt resistor, the steps of a method for characterizing a current sensor and the steps of a method of current measurement for a motor vehicle.

### Detailed description of the invention

In an embodiment, the step of establishing a relationship between the characterization data R_{batch}(T) of the shunt resistor and the current sensor comprises the steps of:
- marking, on the shunt resistor, an identification code readable by a reading machine;
- linking the identification code to the batch characterization data R_{batch}(T) of the shunt resistor;
- reading the characterization data R_{batch}(T) of the shunt resistor by a reading machine, and
- storing the read data in the electronic control unit (ECU) of the current sensor by the reading machine.

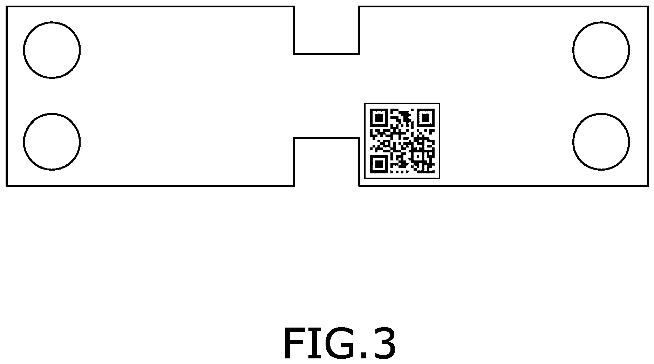

In the shown embodiment of figure 3, the shunt resistor comprises an identification code readable by a reading device. The shunt resistor is marked with an identification code that can be, for instance, scanned. The identification code comprises, for instance is linked, to the batch characterization data R_{batch}(T) of the shunt resistor. Thus, the method comprises the step of reading the batch characterization data R_{batch}(T) of the shunt resistor by a reading device and providing the read data to the electronic control unit (ECU) of the current sensor by the reading device. The scanning of the identification code allows access to, for instance, a look-up table resistance vs temperature.

The identification code may comprise a two-dimensional code, for instance, a data matrix such as a barcode or a QR code. Figure 3 discloses an embodiment of a shunt resistor marked with an identification code linked to the batch characterisation data R_{batch}(T) of the shunt resistor.

As previously stated, the identification code may be printed on an outer surface of the shunt resistor or in a packaging.

By marking the identification code (QR, barcode, etc.) on a visible side of the shunt resistor the batch characterization data R_{batch}(T) of the manganin batch from which the shunt resistor was produced is known. Therefore, it may be known how the material behaves, i.e., the manganin resistivity as a function of temperature.

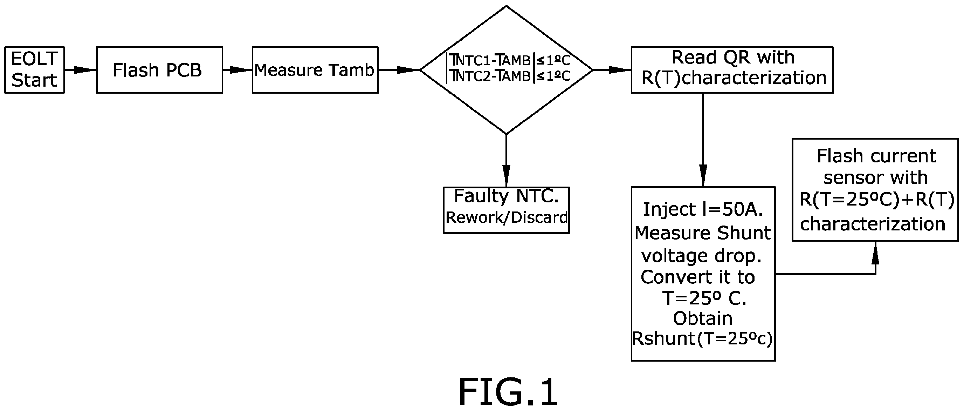

Figure 1 discloses an embodiment of the calibration steps that are performed in an end-of-line testing of a current sensor.
- mounting the shunt resistor into the circuit board of the current sensor, for instance, on a PCB (Printed Circuit Board). Preferably by welding such that the shunt resistor is welded to the circuit board,
- measuring the ambient temperature,
- reading out an identification code (i.e., barcode) printed on the shunt resistor,
- receiving in the electronic control unit (ECU) the characterization data associated with the barcode,
- injecting current into the current sensor. In an embodiment, the current will be, preferably, approximately 5 and 500 amperes, preferably between 10 and 200, more preferably 50 amperes.
   It has been seen that if the current is more than 50 amperes the shunt resistor starts to heat up, therefore it disturbs the measurement. That is, if we use a thermometer located in the room and it reads 23.5 °C, we are assuming that the shunt is also at 23.5 °C. If we inject more than 50 amperes, for instance, 600 amperes, the shunt resistor gets hot and it is no longer at 23.5 °C resulting in a disturbed measurement. On the other hand, if too few amperes are injected, for instance, 1 ampere, the shunt will not measure properly.
- measuring the voltage drop at the ends of the shunt resistor,
- obtaining the measured resistance (R_{T}) of the current sensor at the reference temperature through Ohm's law. Dividing the measured voltage drop (V_{measured}) by the provided current (I_{provided}), R_{T}=V_{measured/}I_{provided/} and
- flashing the current sensor with the above data, by including the information regarding the value of resistance at the reference temperature to the current sensor programming.

For instance, in an embodiment, the electronic control unit (ECU) is flashed with the batch characterization curve or data R_{batch}(T) of the shunt resistor and the value of the resistance (R_{T}) of the shunt resistor at a reference temperature.

| | | | | | |
|---|---|---|---|---|---|
| P1 | = | X | ohm.m | --> | @-50°C |
| P2 | = | Y | ohm.m | --> | @150°C |

Shunt resistor resistance at the reference temperature: 1 ohm.m --> @25°C

In an embodiment, the electronic control unit (ECU) calculates a polynomial function from the provided characterization data R_{batch}(T) and the electronic control unit (ECU) calculates the thermal compensation of the current sensor from the measured resistance (R_{T}) at the reference temperature, for instance, the ambient temperature, and the polynomial function. The polynomial function comprises a polynomial function of 3Suprd /Supor 4Supth /Suporder.

The characterized current sensor may be installed in, for instance, a battery management system (BMS). As a result, the vehicle manufacturer in which the current sensor is installed would mount the BMS to a vehicle and the current sensor would perform the following steps in operation:
- measuring the operating temperature by a thermometer of the current sensor, for example, 5°C;
- calculating by the current sensor the shunt resistor resistance, based on the reference temperature (5°C) and according to the characterization curve (P1, P2);
- measuring by the current sensor the shunt resistor voltage drop (V);
- determining the current (I) with Ohm's law: I = V / R, taking the thermal compensation of R (resistance) calculated in the previous steps.

As previously stated, for obtaining the batch characterization data R_{batch}(T) of the shunt resistor, in an embodiment, manganin alloy batches are introduced into a temperature-varying chamber. The resistivity of the manganin batch is obtained at, at least, two different temperatures, preferably three or more different temperatures, for instance between five and ten different temperatures.

Alternatively, every shunt resistor can be introduced into the temperature-varying chamber or at least one shunt resistor manufactured from the alloy material batch is introduced.

For example, if we have four batches of 500 shunt resistors, 2000 characterizations had to be made. This is much more expensive than doing four characterizations of the four batches of the manganin alloy. Performing bulk material temperature calibration is less time-consuming for the shunt resistor manufacturer.

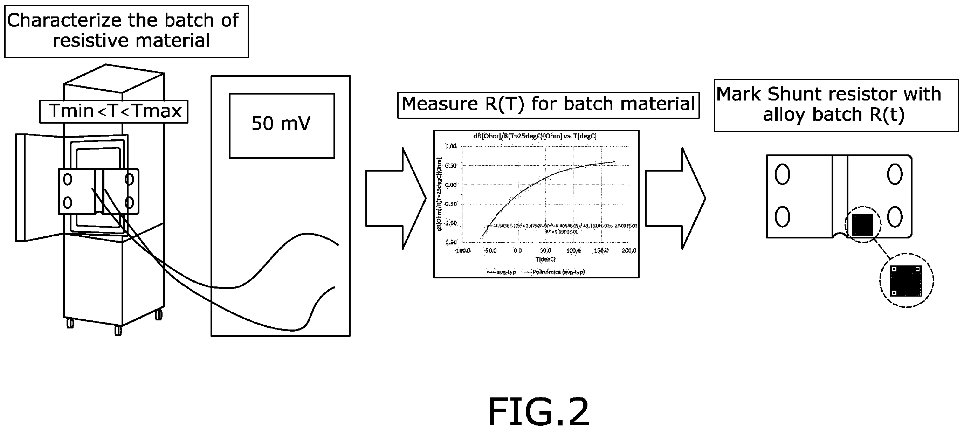

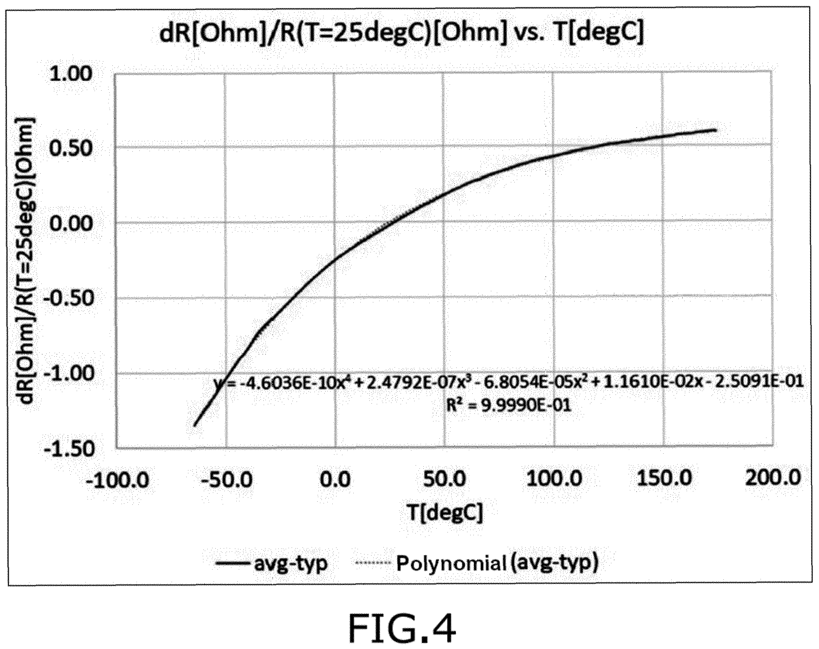

Figure 2 discloses an embodiment of the steps performed for the characterization of the shunt resistor:
- measuring the resistivity of the batch of material alloy and its relationship with temperature;
- producing shunt resistors from the batch material alloy;
- marking each shunt resistor with an identification code (i.e., a barcode) comprising at least the relationship between the temperature and the resistance, i.e., the batch characterization data R_{batch}(T). The table showing the characterization data of the shunt is also represented in figure 4.

In an embodiment, the method for obtaining the batch characterization data R_{batch}(T) of the shunt resistor may comprise the following steps:
- providing at least one batch of shunt resistor's raw material. For instance, a Copper Manganin alloy. Alternatively, at least a shunt resistor made from the same batch of alloy material than the current sensor shunt resistor is provided,
- placing the batch of alloy material or the shunt resistor made from the same batch than the shunt resistor into a temperature-varying chamber for varying the temperature,
- measuring the resistivity of the batch at at least two different temperatures respective at least two voltage drops via a voltmeter. In particular, measuring, at least ten temperatures of the at least one batch.
- providing a relationship between the measured resistivity and temperature of the at least one batch. Preferably, generating a look-up table of resistance vs temperature of the at least one batch. Alternatively, a functional dependence giving the resistance as a function of the temperature can be generated.
- manufacturing the shunt resistors from the material of the batch.

In an embodiment, for obtaining the batch characterization data R_{batch}(T) of the shunt resistor and after introducing into the temperature-varying chamber the batch of alloy material or the shunt from the same batch than the shunt resistor of the current sensor, the following steps are performed:
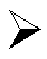 connecting a voltmeter to the shunt resistor or to the alloy material,
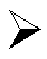 connecting a power supply to the shunt resistor or to the alloy material,
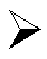 providing a current from the current supply to the shunt resistor or to the alloy material,
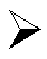 measuring the voltage drop at the shunt resistor or at the alloy material with the voltmeter,
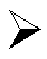 varying the temperature of the chamber and repeating the steps of providing a current and measuring the voltage drop at least at two different temperatures,
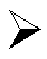 obtaining the resistivities or the resistances R_{batch}(T) of the alloy material or of the shunt resistor with respect to the temperature by Ohm Law.

Figure 4 discloses how the resistance (ohms) of a shunt resistor changes according to the temperature. The characterization curves of the raw material alloy would provide the resistivity (ohms.m). It is known that the resistance of the manganin is 4.9 x 10 ^-7. As it can be seen in figure 3, the resistivity of the material can increase by % when passing from -50°C to 150°C. Figure 4 discloses resistance (ohms), and that of the material is resistivity (ohms.meter), but the shape of the curve is the same.

According to the above described, in a further embodiment, the following steps can be performed onto the shunt resistor:
- marking each shunt resistor with an identification code (i.e., a barcode or a QR code), said identification code being particularly configured to be read by a reading device. The shunt resistor can be marked on its surface or in any other location than for example the packaging.
- storing the batch characterization data R_{batch}(T), for example, in the cloud (i.e., cloud storage), wherein the characterization data R_{batch}(T) may contain data such as a lot number, material used (exact % manganin alloy), and a look-up table of resistance vs temperature. Furthermore, the batch characterization data R_{batch}(T) may contain further information related to product name, value indicating characteristics, producer, production site, production date, etc.

It allows to know which shunt resistor has come from which batch. For example, if we have several batches, and a number of shunt resistors come out of each one, it allows to quickly know which shunt resistor has come out of which batch.

If a readable code is located on the shunt resistor, the following steps are performed onto the current sensor:
- reading out the identification code printed on a visible surface of the shunt resistor, for example, by means of a code reading machine;
- downloading the batch characterization data R_{batch}(T) of the shunt resistor after reading out the identification code.

The group of steps that are performed onto the shunt resistor may be carried out in a different location than the steps carried out onto the current sensor.

According to a non-limitative example, if a shunt resistor weighs, for example, 50 grams and the manufacturer receives 100 kg of material (Cu-Mn alloy - manganin) in five batches (each 20 kg batch), the manufacturer will produce 2000 shunt resistors.

According to the above, the second site may receive 2000 shunt resistors. Each shunt resistor, although ideally identical, are made from different materials, from different batches of manganin. The shunt resistors are scanned and thus it is known that a particular shunt resistor corresponds to a batch of manganin had exactly one alloy of 86.08% copper, 11.94% manganese, and 1.98% nickel. And also, that for this particular alloy, the resistance varies in a certain way depending on the temperature, characterization curves.

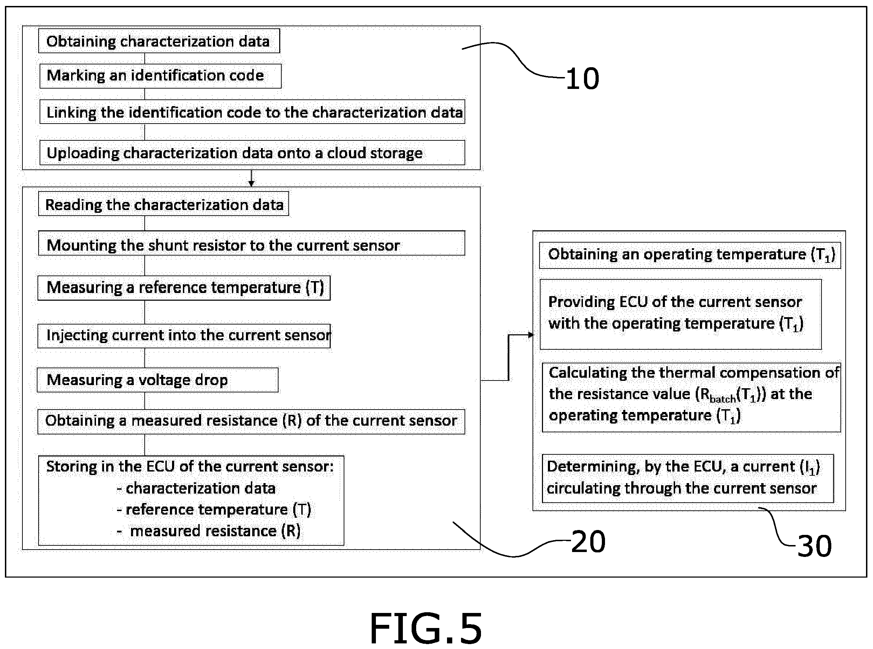

Figure 5 shows a block diagram of an embodiment of the steps of a method for characterizing a shunt resistor (10), an embodiment of the steps of a method for characterizing a current sensor (20) and an embodiment of the steps of a method of current measurement for a motor vehicle (30).

Schematically, the steps involved in the embodiment of figure 5 of a method for characterizing a shunt resistor (10) are as follows:
1) Obtaining the batch characterization data of the shunt resistor:
   - two or more resistivity values are measured, or
   - two or more resistance values are measured.
2) Marking an identification code (QR, barcode, etc.)
   - On the surface of the shunt resistor, or
   - On the packaging
3) Linking the identification code to the batch characterization data
4) Uploading the batch characterization data onto a cloud storage unit
   - alternatively: to any (physical) memory (i.e., pen-drive)
   Schematically, the steps involved in the embodiment of figure 5 of a method for characterizing a current sensor (20) are as follows:
5) Providing the batch characterization data and the shunt resistor.
   - supplying them, for instance, by downloading the batch characterization data from cloud or pen
6) Establishing a relationship between the batch characterization data of the shunt resistor and the current sensor
   - reading an identification code and storing the data in the ECU, and
   - mounting the shunt resistor in the current senor. In particular, mounting is carried out by welding.
7) Measuring a reference temperature (T)
   - by a thermometer in the room,
   - by a thermometer of the current sensor. It may be a laser or the like to measure the reference temperature (T).
8) Obtaining a measured resistance of the current sensor
   - by Ohm Law (I = V / R)
      - providing current (50 A)
      - measuring voltage drop (a realistic value may be 2.5 mV (millivolts))
      - dividing voltage drop by provided current
9) Storing in the ECU current sensor:
   - batch characterization data of the shunt resistor,
   - reference temperature (T),
   - measured resistance.
   Schematically, the steps involved in the embodiment of figure 5 of a method of current measurement for a motor vehicle (30) are as follows:
10) Obtaining an operating temperature
   - by a thermometer current sensor
   - by any other thermometer located in the vehicle
11) Providing the operation temperature into the ECU of the current sensor
12) Calculating (correcting / compensating) resistance of the current sensor based on the operating temperature.
13) Determining current circulating through the current sensor based on the corrected resistance of the current sensor.

## Claims

1. Method for characterizing a current sensor configured to calculate a thermal compensation of a sensed current, the current sensor comprising an electronic control unit (ECU) and a shunt resistor connected to the electronic control unit (ECU), the shunt resistor being manufactured from a portion of a batch of an alloy material, the characterizing method comprising the steps of:
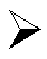 providing a shunt resistor and a batch characterization data of resistivity or resistance versus temperature R_{batch}(T) linked to the shunt resistor,
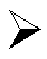 mounting the shunt resistor linked to the batch characterization data of resistivity or resistance versus temperature R_{batch}(T) to the current sensor,
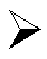 measuring by a temperature sensor a reference temperature (T) at the current sensor,
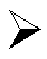 obtaining a measured resistance (R_{T}) of the current sensor at the reference temperature (T); and
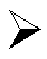 storing in the electronic control unit (ECU) of the current sensor the following data:
- the batch characterisation data R_{batch}(T) linked to the shunt resistor mounted on the current sensor;
- the reference temperature (T) at the current sensor; and
- the measured resistance (R_{T}) of the current sensor at the reference temperature (T).

2. Method for characterizing a current sensor, according to claim 1, wherein the step of storing in the electronic control unit (ECU) of the current sensor the batch characterisation data R_{batch}(T) linked to the shunt resistor comprises the step of reading by a reading machine an identification code marked on the shunt resistor and linked to the batch characterisation data R_{batch}(T) of the shunt resistor.

3. Method for characterizing a current sensor, according to claim 2, wherein the identification code comprises a two-dimensional code.

4. Method for characterizing a current sensor, according to claim 3, wherein the two-dimensional code is a data matrix such as a barcode or a QR code.

5. Method for characterizing a current sensor, according to any preceding claim 2 to 4, wherein the identification code is printed on an outer surface of the shunt resistor.

6. Method for characterizing a current sensor, according to any preceding claim, wherein the batch characterization data of resistivity or resistance versus temperature R_{batch}(T) of the shunt resistor comprises:
• two or more resistivity values measured at two or more temperatures of the batch of alloy material of the shunt resistor, or
• two or more resistance values measured at two temperatures of one of the shunt resistors made from the same batch of alloy material than the shunt resistor of the current sensor.

7. Method for characterizing a current sensor, according to claim 6, wherein the batch characterization data R_{batch}(T) of the shunt resistor comprises a look-up table of resistivity or resistance versus temperature or a functional dependence giving the resistivity or resistance as a function of the temperature.

8. Method for characterizing a current sensor, according to any preceding claim, wherein the electronic control unit (ECU) is configured to calculate a polynomial function from the provided batch characterization data R_{batch}(T) of the shunt resistor.

9. Method for characterizing a current sensor, according to any preceding claim, wherein the shunt resistor comprises a first end and a second end and the step of obtaining the measured resistance (R_{T}) of the current sensor at the reference temperature (T) is performed by Ohms Law R_{T}=V/I by providing to the first end and/or the second end of the shunt resistor a set current or a set voltage drop and measuring the voltage drop or the current accordingly.

10. Method for characterizing a current sensor, according to claim 9, wherein the step of obtaining the measured resistance (R_{T}) of the current sensor at the reference temperature (T) comprises the following steps:
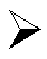 connecting a first terminal and a second terminal of the current sensor to outputs of a current supply,
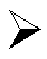 connecting the first and the second end of the shunt resistor to inputs of a voltmeter,
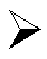 providing the current sensor with a current from the current supply (I_{provided}),
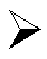 measuring the voltage drop (V_{measured}) at the shunt resistor with the voltmeter at the reference temperature (T),
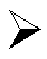 obtaining the measured resistance (R_{T}) of the current sensor at the reference temperature (T) by dividing the measured voltage drop (V_{measured}) by the provided current (I_{provided}), R_{T}=V_{measured/}I_{provided},

11. Method for characterizing a current sensor, according to claim 10, wherein the current supply (I_{provided}) provides approximately between 5 and 500 amperes, preferable between 10 and 200 amperes, more preferably 50 amperes.

12. Method for characterizing a current sensor, according to any preceding claim, wherein the alloy material comprises manganin and copper.

13. Method for characterizing a current sensor, according to any preceding claim, wherein it comprises the following steps for obtaining the batch characterization data R_{batch}(T) of the shunt resistor:
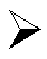 introducing into a temperature-varying chamber:
• the batch of alloy material of the current sensor shunt resistor, or
• at least a shunt resistor made from the same batch of alloy material than the shunt resistor of the current sensor,
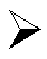 connecting a voltmeter to the shunt resistor or to the alloy material,
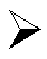 connecting a power supply to the shunt resistor or to the alloy material,
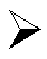 providing a current from the current supply to the shunt resistor or to the alloy material,
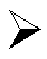 measuring the voltage drop at the shunt resistor or at the alloy material with the voltmeter,
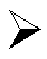 varying the temperature of the chamber and repeating the steps of providing a current and measuring the voltage drop at least at two different temperatures,
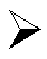 obtaining the resistivities or the resistances R_{batch}(T) of the alloy material or of the shunt resistor with respect to the temperature (T) by Ohm Law.

14. Method of current measurement for a motor vehicle comprising the steps of:
- characterizing a current sensor according to any preceding claim;
- obtaining an operating temperature (T₁);
- providing the electronic control unit (ECU) of the current sensor with the operating temperature (T₁);
- calculating the thermal compensation of the resistance value
(R_{batch}(T₁)) at the operating temperature (T₁) based on:
- the batch characterisation data R_{batch}(T) of the shunt resistor;
- the reference temperature (T) at the current sensor of the characterizing steps; and
- the measured resistance (R_{T}) of the current sensor at the reference temperature (T),
- determining, by the electronic control unit (ECU), a current (I₁)
circulating through the current sensor from the thermally compensated resistance value.

15. Current sensor configured to calculate a thermal compensation of a sensed current, the current sensor comprising an electronic control unit (ECU), a shunt resistor connected to the electronic control unit (ECU) and being manufactured from a portion of a batch of an alloy material, the electronic control unit (ECU) of the current sensor comprising the following data:
- batch characterization data R_{batch}(T) of the shunt resistor;
- a characterization reference temperature (T) at the current sensor; and
- a characterization measured resistance (R_{T}) of the current sensor at the reference temperature (T),
the electronic control unit (ECU) being configured to:
- be provided with an operating temperature (T₁);
- calculate the thermal compensation of the resistance value (R_{batch}(T₁)) at the operating temperature (T₁) based on:
- the batch characterisation data R_{batch}(T) of the shunt resistor;
- the reference temperature (T) at the current sensor of the characterizing steps; and
- the measured resistance (R_{T}) of the current sensor at the reference temperature (T),
- determine, by the electronic control unit (ECU), a current (I₁) circulating through the current sensor from the thermally compensated resistance value.
